# EUROPEAN PATENT APPLICATION

(11) **EP 1 349 275 A2**
(43) Date of publication of application: **01.10.2003**
(21) Application number: 03251841.7
(22) Date of filing: 24.03.2003
(51) Int. Cl.: H03J 1/00

(54) **Integrated circuit**

(30) Priority: 29.03.2002 JP 2002097593
(71) Applicant: ALPS ELECTRIC CO., LTD., Ota-ku Tokyo 145 (JP)
(72) Inventor: Yamamoto, Masaki, Ota-ku, Tokyo 145 (JP)
(74) Representative: Kensett, John Hinton

(57) **Abstract**

The integrated circuit includes a power supply terminal (10h) to which a power supply voltage is applied, a clock terminal (30e) to which a clock signal is inputted, a data terminal (30d) to which data is inputted, an address selection terminal (10f) to which a DC voltage corresponding to address data which identifies own presence in the inputted data is inputted, and an interface (33) which is connected to the clock terminal, the data terminal and the address selection terminal, wherein a relay terminal (10g) , a first resistance (15a) which is connected between the power supply terminal and the relay terminal, and a second resistance (15b) which is connected between the address selection terminal and a ground are provided to the interface.

## Description

### BACKGROUND OF THE INVENTION

### 1. Field of the Invention

The present invention relates to an integrated circuit used in a television tuner or the like, and more particularly to an integrated circuit which can easily set a voltage for identifying (specifying) an own address.

### 2. Description of Related Art

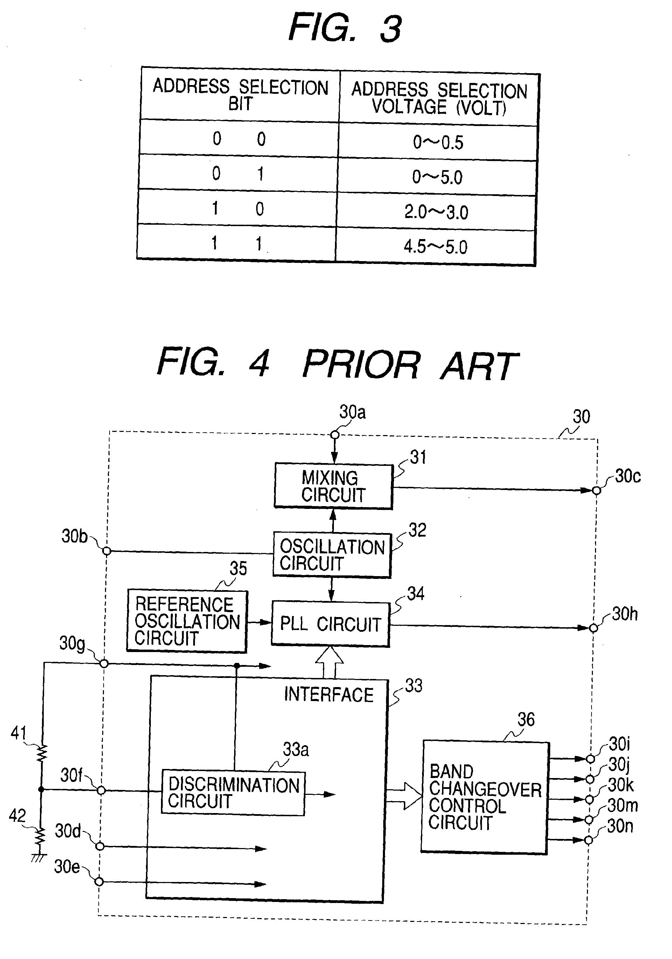

Fig. 4 is a schematic circuit constitutional view of a conventional integrated circuit 30 which is used in a television tuner. The integrated circuit 30 performs control of selecting channels or the like in response to data inputted from a controller (microprocessor) of a television receiver set not shown in the drawing and, at the same time, converts inputted television signals to intermediate frequency signals.

First of all, television signals selected by an external tuning circuit (not shown in the drawing) are inputted to a mixing circuit 31 through an RF terminal 30a. Further, a local oscillation signal is supplied to the mixing circuit 31 from an oscillation circuit 32. An resonance circuit (not shown in the drawing) which is provided outside is coupled to the oscillation circuit 32 by a resonance circuit terminal 30b. The intermediate frequency signals outputted from the mixing circuit 31 are led to an IF terminal 30c.

On the other hand, from the television receiver set, data which serves for controlling other integrated circuits in the receiver set or which serves for controlling the integrated circuit 30 of the tuner is outputted. This data always contains address data and the integrated circuit to be controlled is identified based on the address data. Accordingly, to control the integrated circuit 30 used in the television tuner, the address data for identifying the integrated circuit 30 is added. Further, to enable the identification of the integrated circuit based on the address data, an address selection voltage is necessary. The address data and the address selection voltage are determined at the television receiver set side.

The above-mentioned data is inputted to a data terminal 30d and, at the same time, a clock signal which accompanies the data is inputted to a clock terminal 30e. This data is inputted to an interface 33. Further, the address selection voltage is applied to an address selection terminal 30f and is inputted to the interface 33 in the same manner. As the address selection voltage, for example, four kinds of voltages, a voltage of 0 to 0.5 volt, a voltage of 2 to 3 volt, a voltage of 4.5 to 5 volt and a voltage of 0 to 5 volt, are provided and one of them is designated.

The address selection voltage is generated outside the integrated circuit 30. That is, divided voltage resistances 41,42 are provided between a power supply terminal 30g and a ground outside the integrated circuit 30, and a voltage set by these divided voltage resistances is applied to the address selection terminal 30f. The address selection voltage is identified by an identifying circuit 33a in the interface 33, and when the correspondence with the address data is obtained, channel selection data or the like which follows the address data is processed.

Of the data inputted to the integrated circuit 30, the channel selection data is inputted to a PLL circuit 34 through the interface 33. On the other hand, a local oscillation signal is inputted to the PLL circuit 34 from the oscillation circuit 32 and, at the same time, a reference frequency signal is inputted to the PLL circuit 34 from a reference oscillation circuit 35. Then, the PLL circuit 34 performs control such that the oscillation circuit 32 oscillates at a given frequency necessary for a channel to be selected and outputs a control voltage for oscillation frequency control to a control voltage terminal 30h. This control voltage is supplied to a resonance circuit or the like so that the oscillation frequency of the oscillation circuit 32 assumes the above-mentioned given frequency.

Further, of the inputted data, band data which serves for changing over a receiving band is inputted to a band changeover control circuit 36 through the interface 33. The band changeover control circuit 36 includes a plurality of changeover terminals 30i to 30n and outputs a changeover voltage of high level or low level to respective changeover terminals.

In the above-mentioned constitution, the address selection voltage which is applied to the integrated circuit is generated outside the integrated circuit. Accordingly, it is necessary to provide the voltage dividing circuit or the like for setting the address voltage. Further, to obtain the designated address voltage, it is necessary to select the resistance value of the voltage dividing circuit in use.

### SUMMARY OF THE INVENTION

It is an object of the present invention to provide an integrated circuit which can overcome such cumbersomeness and can simply apply a designated address selection voltage to the integrated circuit without providing a circuit for setting the address selection voltage outside the integrated circuit.

To achieve the above-mentioned object, the present invention provides an integrated circuit which includes a power supply terminal to which a power supply voltage is applied, a clock terminal to which a clock signal is inputted, a data terminal to which data is inputted, an address selection terminal to which a DC voltage corresponding to address data identifying own presence in the inputted data is inputted, and an interface which is connected to the clock terminal, the data terminal and the address selection terminal, wherein a relay terminal, a first resistance which is connected between the power supply terminal and the relay terminal, and a second resistance terminal which is connected between the address selection terminal and a ground are provided to the interface.

Advantageously, a resistance value of the first resistance and a resistance value of the second resistance are set equal.

### BRIEF EXPLANATION OF DRAWINGS

Fig. 1 is a circuit diagram showing the constitution of an integrated circuit of the present invention;
Fig. 2 is a view showing a format of data inputted to the integrated circuit of the present invention;
Fig. 3 is a view showing the relationship between address selection bits and an address selection voltage in data inputted to the integrated circuit of the present invention; and
Fig. 4 is a circuit diagram showing the constitution of a conventional integrated circuit.

### DESCRIPTION OF PREFERRRED EMBODIMENT

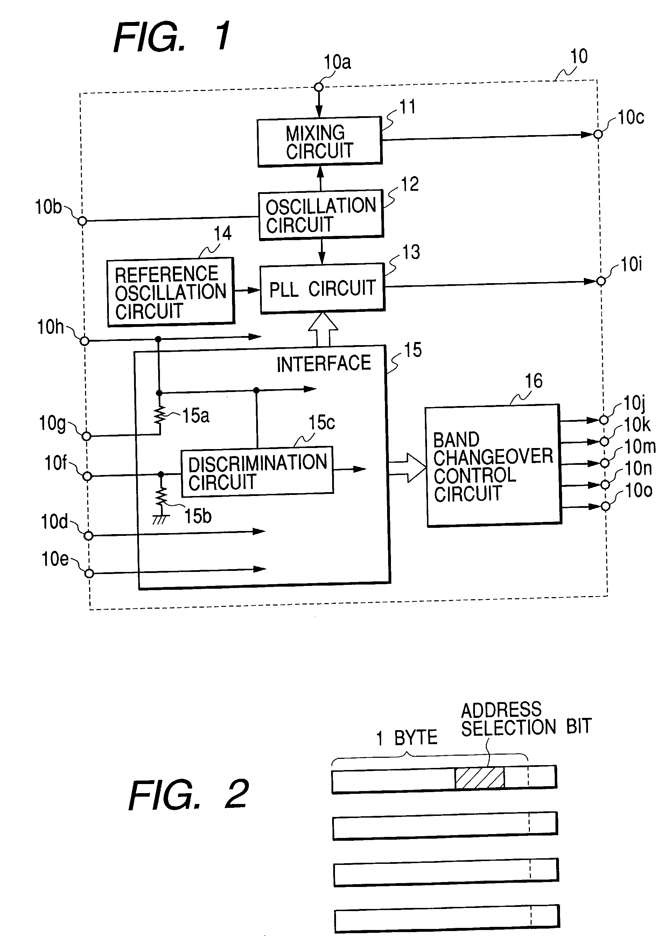

The constitution of an integrated circuit of the present invention is explained in conjunction with Fig. 1. The integrated circuit 10 is incorporated in a television tuner and performs control such as selection of channels in response to data inputted from a controller (microprocessor) of a television receiver set not shown in the drawing and, at the same time, converts the inputted television signals to intermediate frequency signals.

First of all, television signals selected by an external tuning circuit (not shown in the drawing) are inputted to a mixing circuit 11 through an RF terminal 10a. Further, a local oscillation signal is supplied to the mixing circuit 11 from an oscillation circuit 12. An resonance circuit (not shown in the drawing) which is provided outside is coupled to the oscillation circuit 12 by a resonance circuit terminal 10b. The intermediate frequency signals outputted from the mixing circuit 11 is led to an IF terminal 10c. To a PLL circuit 13 which controls the oscillation frequency of the oscillation circuit 12, the oscillation signal is inputted from the oscillation circuit 12 and, at the same time, reference signals are inputted from a reference oscillation circuit 14. Further, to the PLL circuit 13, data transmitted from a television receiver set is inputted through an interface 15.

Although data from the television receiver set is transmitted to an integrated circuit other than a television tuner, a format of the data transmitted to the integrated circuit 10 for the television tuner is configured as shown in Fig. 2 and is inputted to a data terminal 10d. Further, a clock signal which accompanies the data is inputted to a clock terminal 10e. In the data, A indicates address data (8 bits) in which data for identifying the integrated circuit which is subjected to control is contained, B and C indicate frequency data (16 bits) in which data for selecting channels is contained, and D indicates band changeover data (8 bits) in which data for setting the receiving band is contained. Further, an address selection bit which identifies the integrated circuit 10 is contained in 2 bits in the address data.

Further, to operate the identified integrated circuit, it is necessary to apply the address selection voltage corresponding to the address selection bits to the integrated circuit. In this integrated circuit 10, the address selection voltage is applied to an address selection terminal 10f. The relationship between the address selection bits and the address selection voltage is set as shown in Fig. 3, for example. When the address selection bit is (0,0), the address selection voltage is set to 0 to 0.5 volt, when the address selection bit is (0,1), the address selection voltage is set to 0 to 5.0 volt, when the address selection bit is (1,0), the address selection voltage is set to 2.0 to 3.0 volt, and when the address selection bit is (1,1), the address selection voltage is set to 4.5 to 5.0 volt. Further, one of these address selection bits is designated in the integrated circuit 10 by the television receiver set side. For example, when the address selection bit assumes (1,0), the address selection voltage assumes 2.0 to 3.0 volt.

Here, according to the present invention, a relay terminal 10g is provided to the integrated circuit 10, a first resistance 15a is connected between a power supply terminal 10h and the relay terminal 10g, and a second resistance 15b is connected between the address selection terminal 10f and a ground. The resistance value of the first resistance 15a and the resistance value of the second resistance 15b are equal and are set to 5kΩ (kilo ohm), for example. Then, the relay terminal 10g and the address selection terminal 10f are connected by a lead line. As a result, the address selection voltage of 2 .5 volt is applied to the address selection terminal 10f.

Here, when the address selection voltage designated in the integrated circuit 10 is 0 to 0.5 volt, the address selection terminal 10f is held as it is in a state that the terminal 10f is not connected to any terminal. In such a state, the voltage of the address selection terminal 10f assumes 0 volt and hence, the address selection voltage satisfies the voltage of 0 to 0.5 volt. Then, when the address selection voltage of 4.5 to 5.0 volt is designated, the address selection terminal 10f may be connected to the power supply terminal 10h. Further, when the address selection voltage of 0 to 5.0 volt is designated, the address selection terminal 10f may be connected to no terminals or may be connected to the power supply terminal 10h.

Further, when the address selection voltage other than the above-mentioned voltages is designated, to cope with the voltage, a third resistance may be connected between the power supply terminal 10h and the relay terminal 10g or between the address selection terminal 10f and the ground outside the integrated circuit 10.

In any case, by connecting the address selection terminal 10f to either one of the power supply terminal 10h and the relay terminal 10g or neither of these terminals 10h, 10g, it is possible to make the voltage of the address selection terminal match any one of the address selection voltages.

The address selection voltage is identified by an identifying circuit 15c in the interface 15, and when the correspondence between the address selection voltage and the address selection bit is obtained, the frequency data or the like which follows the address data is processed.

Of the data inputted to the integrated circuit 10, the frequency data is inputted to the PLL circuit 13 through the interface 15. Then, the PLL circuit 13 is controlled such that the oscillation circuit 12 is oscillated at a given frequency which is necessary for a channel to be selected and outputs a control voltage necessary for oscillation frequency control to the control voltage terminal 10i. The control voltage is supplied to a resonance circuit or the like. Then, as a result, the above-mentioned oscillation circuit 12 oscillates at the above-mentioned given frequency.

Further, the band changeover data which follows the frequency data is inputted to a band changeover control circuit 16 through the interface 15. The band changeover control circuit 16 includes a plurality of changeover terminals 10j to 10o and outputs a changeover voltage of high level or low level to respective terminals.

As has been described heretofore, according to the present invention, the integrated circuit includes the power supply terminal to which the power supply voltage is applied, the clock terminal to which the clock signal is inputted, the data terminal to which the data is inputted, the address selection terminal to which the DC voltage corresponding to the address data which identifies the own presence in the inputted data is inputted, and the interface which is connected to the clock terminal, the data terminal and the address selection terminal, wherein the relay terminal, the first resistance which is connected between the power supply terminal and the relay terminal, and the second resistance which is connected between the address selection terminal and the ground are provided to the interface. Accordingly, by connecting the address selection terminal to one of the power supply terminal and the relay terminal or neither of these terminals, it is possible to make the voltage of the address selection terminal match any one of the address selection voltages.

Further, since the resistance value of the first resistance and the resistance value of the second resistance are set equal, it is possible to set the address selection voltage which is 1/2 of the power supply voltage.

## Claims

1. An integrated circuit comprising:
a power supply terminal to which a power supply voltage is applied;
a clock terminal to which a clock signal is inputted;
a data terminal to which data is inputted;
an address selection terminal to which a DC voltage corresponding to address data which identifies own presence in the inputted data is inputted; and
an interface which is connected to the clock terminal, the data terminal and the address selection terminal, wherein
a relay terminal, a first resistance which is connected between the power supply terminal and the relay terminal, and a second resistance which is connected between the address selection terminal and a ground are provided to the interface.

2. The integrated circuit according to claim 1, wherein a resistance value of the first resistance and a resistance value of the second resistance are set equal.
